# EUROPEAN PATENT APPLICATION

(11) **EP 4 564 657 A1**
(43) Date of publication of application: **04.06.2025**
(21) Application number: 24213200.9
(22) Date of filing: 15.11.2024
(51) Int. Cl.: H02M 1/00, H02M 1/096, H02M 3/335, H03K 17/00

(54) **POWER CONVERTER AND FEED CIRCUIT**

(30) Priority: 30.11.2023 CN 202311626594
(71) Applicant: Huawei Digital Power Technologies Co., Ltd., Shenzhen, Guangdong 518043 (CN)
(72) Inventor: ZHAO, Jun, 518043 Shenzhen (CN); HU, Yaowei, 518043 Shenzhen (CN); LI, Jianshan, 518043 Shenzhen (CN)
(74) Representative: Gill Jennings & Every LLP

(57) **Abstract**

Embodiments of this application provide a power converter and a feed circuit. The feed circuit of the power converter includes a voltage division component, a voltage and current division component, and an energy storage component. The voltage division component and the current division component are connected in series and then connected to a source and a drain of a switching transistor of a secondary circuit of the power converter. The voltage and current division component is connected in parallel to the energy storage component. An output end of the energy storage component is connected to a power supply end of a drive circuit, and a drive end of the drive circuit is connected to a control end of the switching transistor. When the switching transistor is turned off, a drain-source voltage of the switching transistor is not zero, and a voltage of the voltage division component is greater than a voltage of the voltage and current division component, to clamp a voltage of the energy storage component at a low level. The voltage and current division component avoids an excessively high current flowing into the energy storage component in a parallel current division manner. The energy storage component is configured to store electric energy when the switching transistor is turned off, to supply power to the power supply end of the drive circuit when the switching transistor is turned on. Therefore, the energy storage component may feed power from two ends of the switching transistor and supply power to the power supply end without a risk of overcurrent and overvoltage.

## Description

### TECHNICAL FIELD

This application relates to the field of power electronics, and in particular, to a power converter and a feed circuit.

### BACKGROUND

Currently, a feed circuit is usually configured for a drive circuit of a power converter, and the feed circuit mainly supplies power to the drive circuit by using charge and discharge characteristics of an energy storage element. However, when the feed circuit feeds power at a high voltage, an excessively high voltage or current of the energy storage element causes the feed circuit to fail to work normally, thereby affecting stability of the power converter.

A conventional feed circuit requires a voltage limiter or another logic circuit to avoid an excessively high voltage on an energy storage device, and further requires a semiconductor-type voltage regulator circuit to perform voltage regulation. A circuit topology is complex, and a problem of an excessively high current cannot be resolved. Stability of the feed circuit is still poor.

Therefore, how to simplify the feed circuit and improve the stability of the feed circuit is an urgent technical problem to be resolved currently.

### SUMMARY

Embodiments of this application provide a power converter and a feed circuit, to resolve problems of a complex topology and poor stability of the feed circuit.

According to a first aspect, this application provides a power converter. The power converter includes a transformer, a primary circuit, and a secondary circuit, where the primary circuit is connected to a primary winding of the transformer, the secondary circuit is connected to a secondary winding of the transformer, and a voltage of the primary winding is less than a voltage of the secondary winding. The secondary circuit includes a half-bridge branch, a first storage capacitor, and a second storage capacitor, where the first storage capacitor and the second storage capacitor are connected in series and then connected in parallel to the half-bridge branch, the half-bridge branch includes an upper bridge arm and a lower bridge arm, the upper bridge arm or the lower bridge arm includes two switching transistors with opposite freewheeling directions, a connection point between the upper bridge arm and the lower bridge arm is connected to one end of the secondary winding of the transformer, and a connection point between the first storage capacitor and the second storage capacitor is connected to the other end of the secondary winding of the transformer. The power converter further includes at least one feed circuit, a drive circuit that is correspondingly connected to the feed circuit, and a controller, where the feed circuit and the drive circuit are separately disposed corresponding to the switching transistor; the controller is connected to a control end of each drive circuit, and an output end of each drive circuit is connected to a control end of a corresponding switching transistor. Each feed circuit includes a voltage division component, a voltage and current division component, and an energy storage component, where the voltage division component and the current division component are connected in series and then connected in parallel to a source and a drain of a corresponding switching transistor, the voltage and current division component is connected in parallel to the energy storage component, and an output end of the energy storage component is connected to a power supply end of a corresponding drive circuit. Each voltage division component is configured to: when the corresponding switching transistor is turned off, perform voltage division on a drain-source voltage of the switching transistor, where the drain-source voltage is generated by the secondary circuit by inducing a voltage of the primary circuit. Each voltage and current division component is configured to: when the corresponding switching transistor is turned off, perform voltage division on the drain-source voltage of the switching transistor, and perform current division on a current flowing into the voltage and current division component, where a voltage obtained through voltage division performed by the voltage division component is greater than a voltage obtained through voltage division performed by the voltage and current division component. Each energy storage component is configured to: be charged when the corresponding switching transistor is turned off, and be discharged when the switching transistor is turned on, to supply power to the power supply end of the drive circuit.

Based on the technical solution of this application, the voltage division component clamps voltages of the voltage and current division component and the energy storage component at a low level in a series voltage division manner, to avoid an excessively high voltage of the energy storage component. The voltage and current division component and the energy storage component are connected in parallel for current division, to avoid an excessively high current flowing into the energy storage component. Therefore, the energy storage component may feed power from two ends of the switching transistor and store the power, to supply power to the power supply end of the drive circuit. In the technical solution of this application, no additional active circuit is required for voltage limiting, the topology is simple, and the energy storage component has no risk of overcurrent and overvoltage, so that the stability of the feed circuit is higher.

In a possible embodiment, the voltage division component includes a first capacitor, and the first capacitor is configured to: be charged when the corresponding switching transistor is turned off, and be discharged, when the switching transistor is turned on, to zero charge through a loop including a drain-source path of the switching transistor, the first capacitor, and the voltage and current division component.

It may be understood that, when the switching transistor is turned on, a voltage across two ends returns to zero, and a voltage on the first capacitor is unsustainable and needs to be discharged to zero potential. Otherwise, normal working of the switching transistor is affected. Based on the technical solution in this embodiment, the first capacitor is charged when the switching transistor is turned off, and performs voltage division in a loop in which the first capacitor is connected in series with the voltage and current division component, to keep the voltage and current division component and the energy storage component at a low voltage level. The first capacitor is discharged to zero potential when the switching transistor is turned on.

In a possible embodiment, the voltage division component further includes a first resistor, and the first resistor is connected in parallel to the first capacitor.

It may be understood that, in addition to voltage division performed by using the capacitor device, voltage division may be performed in a resistor-capacitor parallel connection manner.

In a possible embodiment, the voltage and current division component includes a second capacitor and a first diode, where the first diode and the second capacitor are connected in parallel with a same polarity; and the second capacitor is configured to: be charged when the corresponding switching transistor is turned off, and be discharged, when the switching transistor is turned on, to zero charge through a loop including the drain-source path of the switching transistor, the voltage division component, and the second capacitor.

It may be understood that, when the switching transistor is turned on, the voltage across the two ends returns to zero, and a voltage on the second capacitor is unsustainable and needs to be discharged to zero potential. Otherwise, normal working of the switching transistor is affected. Based on the technical solution in this embodiment, the second capacitor performs current division when the switching transistor is turned off, to avoid an excessively high current flowing into the energy storage component, and the capacitor device may further implement effect of output voltage regulation. In addition, when the switching transistor is turned on, because the first diode and the second capacitor are connected in parallel with a same polarity, and a voltage of the voltage division component is greater than a voltage of the voltage and current division component after charging, in a discharging process, the voltage and current division component with a relatively low voltage is generally discharged completely first, and an energy storage device in the voltage division component may continue to be discharged to zero potential by using the first diode.

In a possible embodiment, the voltage and current division component includes a second resistor and a second diode, and the second diode and the second resistor are connected in parallel with a same polarity.

Based on the technical solution in this embodiment, the second resistor performs current division when the switching transistor is turned off, to avoid an excessively high current flowing into the energy storage component.

In a possible embodiment, the voltage and current division component further includes a third resistor, and the third resistor is connected in parallel to the second capacitor.

It may be understood that, in addition to voltage division performed by using the capacitor device, voltage division may be further performed in a resistor-capacitor parallel connection manner.

In a possible embodiment, the energy storage component includes an energy storage capacitor and a third diode that are connected in series, where a negative electrode of the third diode is connected to a positive electrode of the energy storage capacitor, and the energy storage capacitor is connected in parallel to the power supply end of the drive circuit.

It should be noted that, because the energy storage capacitor is mainly configured for energy storage and power supply, a capacitance value of the energy storage capacitor should not be excessively small. In addition, an excessively small capacitance value of the energy storage capacitor may further cause an excessively large ripple of the energy storage capacitor. Therefore, if both the voltage division component and the voltage and current division component are capacitor devices in the foregoing design, a capacitance value of a selected energy storage capacitor should be greater than a capacitance value of the first capacitor and a capacitance value of the second capacitor based on physical characteristics of the capacitor device and characteristics of a series circuit and a parallel circuit.

Based on the technical solution in this embodiment, the negative electrode of the third diode is connected to the positive electrode of the energy storage capacitor, to prevent a current from flowing back to the voltage and current division component when the energy storage capacitor is discharged, resulting in no input at the power supply end of the drive circuit.

According to a second aspect, this application further provides another power converter. The power converter includes a transformer, a primary circuit, and a secondary circuit, where the primary circuit is connected to a primary winding of the transformer, the secondary circuit is connected to a secondary winding of the transformer, and a voltage of the primary winding is less than a voltage of the secondary winding. The secondary circuit includes a half-bridge branch, a first storage capacitor, and a second storage capacitor, where the first storage capacitor and the second storage capacitor are connected in series and then connected in parallel to the half-bridge branch, the half-bridge branch includes an upper bridge arm and a lower bridge arm, the upper bridge arm or the lower bridge arm includes two switching transistors with opposite freewheeling directions, a connection point between the upper bridge arm and the lower bridge arm is connected to one end of the secondary winding of the transformer, and a connection point between the first storage capacitor and the second storage capacitor is connected to the other end of the secondary winding of the transformer. The power converter further includes at least one feed circuit, a drive circuit that is correspondingly connected to the feed circuit, and a controller, where the drive circuit is disposed corresponding to the switching transistor, and the feed circuit is separately disposed corresponding to the upper bridge arm and the lower bridge arm. Each feed circuit includes two voltage division components, two voltage and current division components, and an energy storage component, where the two voltage division components and the two voltage and current division components are separately disposed corresponding to the switching transistors, a voltage division component and a voltage and current division component that correspond to a same switching transistor are connected in series and then connected in parallel to a source and a drain of the corresponding switching transistor, the voltage and current division components are connected in parallel to the energy storage component, and an output end of the energy storage component is connected to power supply ends of two corresponding drive circuits. Each voltage division component is configured to: when the corresponding switching transistor is turned off, perform voltage division on a drain-source voltage of the switching transistor, where the drain-source voltage is generated by the secondary circuit by inducing a voltage of the primary circuit. Each voltage and current division component is configured to: when the corresponding switching transistor is turned off, perform voltage division on the drain-source voltage of the switching transistor, and perform current division on a current flowing into the voltage and current division component, where a voltage obtained through voltage division performed by the voltage division component is greater than a voltage obtained through voltage division performed by the voltage and current division component. Each energy storage component is configured to: be charged when the corresponding switching transistor is turned off, and be discharged when the switching transistor is turned on, to supply power to the power supply ends of the connected drive circuits.

Based on the technical solution of this application, the voltage division component and the voltage and current division component are connected in series for voltage division, to clamp voltages of the voltage and current division component and the energy storage component at a low level, to avoid an excessively high voltage of the energy storage component. The voltage and current division component and the energy storage component are connected in parallel for current division, to avoid an excessively high current flowing into the energy storage component. Therefore, the energy storage component may feed power from two ends of the switching transistor and store the power, to supply power to the power supply ends of the drive circuits. In the technical solution of this application, no additional active circuit is required for voltage limiting, the topology is simple, and the energy storage component has no risk of overcurrent and overvoltage, so that the stability of the feed circuit is higher.

In addition, compared with the power converter in the first aspect that stores energy by using two energy storage components and separately supplies power to power supply ends of two drive circuits, in the technical solution in this embodiment, only one energy storage component is needed to supply power to the power supply ends of the two drive circuits, thereby reducing hardware costs.

In a possible embodiment, the voltage division component includes a first capacitor, and the first capacitor is configured to: be charged when the corresponding switching transistor is turned off, and be discharged, when the switching transistor is turned on, to zero charge through a loop including a drain-source path of the switching transistor, the first capacitor, and the voltage and current division component.

It may be understood that, when the switching transistor is turned on, a voltage across two ends returns to zero, and a voltage on the first capacitor is unsustainable and needs to be discharged to zero potential. Otherwise, normal working of the switching transistor is affected. Based on the technical solution in this embodiment, the first capacitor is charged when the switching transistor is turned off, and performs voltage division in a loop in which the first capacitor is connected in series with the voltage and current division component, to keep the voltage and current division component and the energy storage component at a low voltage level. The first capacitor is discharged to zero potential when the switching transistor is turned on.

In a possible embodiment, the voltage division component further includes a first resistor, and the first resistor is connected in parallel to the first capacitor.

It may be understood that, in addition to voltage division performed by using the capacitor device, voltage division may be performed in a resistor-capacitor parallel connection manner.

In a possible embodiment, the voltage and current division component includes a second capacitor and a first diode, where the first diode and the second capacitor are connected in parallel with a same polarity; and the second capacitor is configured to: be charged when the corresponding switching transistor is turned off, and be discharged, when the switching transistor is turned on, to zero charge through a loop including the drain-source path of the switching transistor, the voltage division component, and the second capacitor.

It may be understood that, when the switching transistor is turned on, the voltage across the two ends returns to zero, and a voltage on the second capacitor is unsustainable and needs to be discharged to zero potential. Otherwise, normal working of the switching transistor is affected. Based on the technical solution in this embodiment, the second capacitor performs current division when the switching transistor is turned off, to avoid an excessively high current flowing into the energy storage component, and the capacitor device may further implement effect of output voltage regulation. In addition, when the switching transistor is turned on, because the first diode and the second capacitor are connected in parallel with a same polarity, and a voltage of the voltage division component is greater than a voltage of the voltage and current division component after charging, in a discharging process, the voltage and current division component with a relatively low voltage is generally discharged completely first, and an energy storage device in the voltage division component may continue to be discharged to zero potential by using the first diode.

In a possible embodiment, the voltage and current division component includes a second resistor and a second diode, and the second diode and the second resistor are connected in parallel with a same polarity.

Based on the technical solution in this embodiment, the second resistor performs current division when the switching transistor is turned off, to avoid an excessively high current flowing into the energy storage component.

It may be understood that, in addition to voltage division performed by using the capacitor device, voltage division may be further performed in a resistor-capacitor parallel connection manner.

In a possible embodiment, the voltage and current division component further includes a third resistor, and the third resistor is connected in parallel to the second capacitor.

It should be noted that, because the energy storage capacitor is mainly configured for energy storage and power supply, a capacitance value of the energy storage capacitor should not be excessively small. In addition, an excessively small capacitance value of the energy storage capacitor may further cause an excessively large ripple of the energy storage capacitor. Therefore, if both the voltage division component and the voltage and current division component are capacitor devices in the foregoing design, a capacitance value of a selected energy storage capacitor should be greater than a capacitance value of the first capacitor and a capacitance value of the second capacitor based on physical characteristics of the capacitor device and characteristics of a series circuit and a parallel circuit.

In a possible embodiment, the energy storage component includes an energy storage capacitor, a third diode, and a fourth diode, where a negative electrode of the third diode and a negative electrode of the fourth diode are connected to a positive electrode of the energy storage capacitor, and an output end of the energy storage capacitor is connected to the power supply ends of the two corresponding drive circuits.

Based on the technical solution in this embodiment, the negative electrode of the third diode and the negative electrode of the fourth diode are connected to the positive electrode of the energy storage capacitor, to prevent a current from flowing back to the two voltage and current division components when the energy storage capacitor is discharged, resulting in no input at the power supply ends of the drive circuits.

According to a third aspect, this application further provides a feed circuit. The feed circuit includes a voltage division component, a voltage and current division component, and an energy storage component, where the voltage division component and the current division component are connected in series and then connected to a source and a drain of a switching transistor, the voltage and current division component is connected in parallel to the energy storage component, an output end of the energy storage component is connected to a power supply end of a drive circuit, and a drive end of the drive circuit is connected to a control end of the switching transistor. When the switching transistor is turned off, a drain-source voltage variation of the switching transistor is not zero, and a voltage of the voltage division component is greater than a voltage of the voltage and current division component. The energy storage component is configured to store electric energy when the switching transistor is turned off, where the electric energy stored in the energy storage component is used to supply power to the power supply end of the drive circuit.

Based on the technical solution of this application, the voltage division component clamps voltages of the voltage and current division component and the energy storage component at a low level in a series voltage division manner, to avoid an excessively high voltage of the energy storage component. The voltage and current division component and the energy storage component are connected in parallel for current division, to avoid an excessively high current flowing into the energy storage component. Therefore, the energy storage component may feed power from two ends of the switching transistor and store the power, to supply power to the power supply end of the drive circuit. In the technical solution of this application, no additional active circuit is required for voltage limiting, the topology is simple, and the energy storage component has no risk of overcurrent and overvoltage, so that the stability of the feed circuit is higher.

According to a fourth aspect, this application further provides a feed circuit. The feed circuit includes two voltage division components, two voltage and current division components, and an energy storage component, where either of the voltage division components and either of the current division components are connected in series and then connected to a source and a drain of a switching transistor, the other voltage division component and the other current division component are connected in series and then connected to a source and a drain of another switching transistor, and the two switching transistors are connected in series and have opposite freewheeling directions. The two voltage and current division components are separately connected in parallel to the energy storage component, an output end of the energy storage component is connected to power supply ends of two drive circuits, and a drive end of each drive circuit is connected to a control end of a corresponding switching transistor. When either of the switching transistors is turned off, a drain-source voltage variation of the switching transistor is not zero, and a voltage of the voltage division component corresponding to the switching transistor is greater than a voltage of the voltage and current division component corresponding to the switching transistor. The energy storage component is configured to store electric energy when the switching transistor is turned off, where the electric energy stored in the energy storage component is used to supply power to the power supply ends of the two drive circuits.

Based on the technical solution of this application, the voltage division component and the voltage and current division component are connected in series for voltage division, to clamp voltages of the voltage and current division component and the energy storage component at a low level, to avoid an excessively high voltage of the energy storage component. The voltage and current division component and the energy storage component are connected in parallel for current division, to avoid an excessively high current flowing into the energy storage component. Therefore, the energy storage component may feed power from two ends of the switching transistor and store the power, to supply power to the power supply ends of the drive circuits. In the technical solution of this application, no additional active circuit is required for voltage limiting, the topology is simple, and the energy storage component has no risk of overcurrent and overvoltage, so that the stability of the feed circuit is higher.

In addition, compared with the power converter in the first aspect that stores energy by using two energy storage components and supplies power to power supply ends of two drive circuits, in the technical solution in this embodiment, only one energy storage component is needed to supply power to the power supply ends of the two drive circuits, thereby reducing hardware costs.

### BRIEF DESCRIPTION OF DRAWINGS

FIG. 1 is a schematic of a structure of a feed circuit;
FIG. 2a is a schematic of a structure a power converter according to an embodiment of this application;
FIG. 2b is a schematic of a structure of another power converter according to an embodiment of this application;
FIG. 3a is a schematic of a structure a power converter according to an embodiment of this application;
FIG. 3b is a schematic of a structure of still another power converter according to an embodiment of this application;
FIG. 3c is a schematic of a structure of still another power converter according to an embodiment of this application;
FIG. 3d is a schematic of a structure of still another power converter according to an embodiment of this application;
FIG. 3e is a schematic of a structure of still another power converter according to an embodiment of this application;
FIG. 3f is a schematic of a structure of still another power converter according to an embodiment of this application;
FIG. 3g is a schematic of a structure of still another power converter according to an embodiment of this application;
FIG. 4a is a schematic of a structure of still another power converter according to an embodiment of this application;
FIG. 4b is a schematic of a structure of still another power converter according to an embodiment of this application;
FIG. 4c is a schematic of a structure of still another power converter according to an embodiment of this application;
FIG. 4d is a schematic of a structure of still another power converter according to an embodiment of this application;
FIG. 4e is a schematic of a structure of still another power converter according to an embodiment of this application;
FIG. 4f is a schematic of a structure of still another power converter according to an embodiment of this application;
FIG. 5a is a schematic of a structure of a feed circuit according to an embodiment of this application; and
FIG. 5b is a schematic of a structure of another feed circuit according to an embodiment of this application.

### DESCRIPTION OF EMBODIMENTS

For ease of description and understanding of the technical solutions in this application, an application scenario of this application is first described.

Currently, a feed circuit is generally configured for a drive circuit of a power converter, and the feed circuit mainly supplies power to the drive circuit by using charge and discharge characteristics of an energy storage element. However, when the feed circuit feeds power at a high voltage, an excessively high voltage or current of the energy storage element causes the feed circuit to fail to work normally, thereby affecting stability of the power converter.

A conventional feed circuit requires a voltage limiter or another logic circuit to prevent an excessively high voltage on an energy storage device, and further requires a semiconductor-type voltage regulator circuit to perform voltage regulation. A circuit topology is complex, and a problem of an excessively high current cannot be resolved. Stability of the feed circuit is still poor.

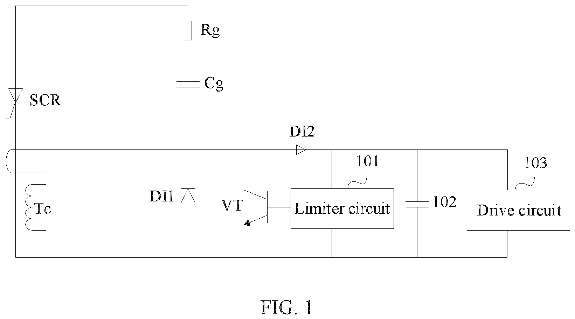

For example, in a conventional feed circuit shown in FIG. 1, the feed circuit includes a thyristor SCR, a capacitor Cg, a resistor Rg, a diode DI1, a diode DI2, a triode VT, a current transformer Tc, a limiter circuit 101, a capacitor 102, and a drive circuit 103.

A working process of the circuit shown in FIG. 1 is as follows.

When a circuit in which the thyristor SCR is located is in a cut-off state, an RC buffer circuit including the resistor Rg and the capacitor Cg performs voltage coupling on two ends of the thyristor SCR to obtain energy, to supply power to the drive circuit 103. After the circuit in which the thyristor SCR is located is conducted, a voltage drop on the thyristor SCR is very low, and therefore, energy cannot be fed from a voltage anymore. In this state, the current transformer Tc performs current coupling to feed energy, to supply power to the drive circuit 103.

When a voltage on the capacitor 102 reaches a specific amplitude, the limiter circuit 101 controls the triode VT to be turned on, to stop an energy storage process, thereby preventing the voltage on the capacitor 102 from being excessively high.

It may be understood that, the conventional feed circuit needs to rely on the RC buffer circuit and the current transformer Tc to feed power in a hybrid manner, and control logic is complex. In addition, the conventional feed circuit further needs the additional limiter circuit 101 to control the voltage on the capacitor 102, to avoid damage caused by overvoltage of the capacitor, resulting in a complex topology and poor stability of the feed circuit.

Therefore, how to simplify the feed circuit and improve the stability of the feed circuit is an urgent technical problem to be resolved currently.

Based on the foregoing problem, embodiments of this application provide a power converter and a feed circuit, to resolve problems of a complex topology and poor stability of the feed circuit in the conventional technology.

The following describes, with reference to the foregoing described application scenario and with reference to the accompanying drawings, a power converter provided in an example embodiment of this application. It should be noted that the foregoing application scenario is merely shown for ease of understanding a principle of this application, and this embodiment of this application is not limited in this aspect. For example, the technical solutions of this application may be modified and varied to be applied to products such as an inverter, a charger, a server power supply, and a special power supply. This application is intended to cover these modifications and variations provided that the design principles of this application are not departed from.

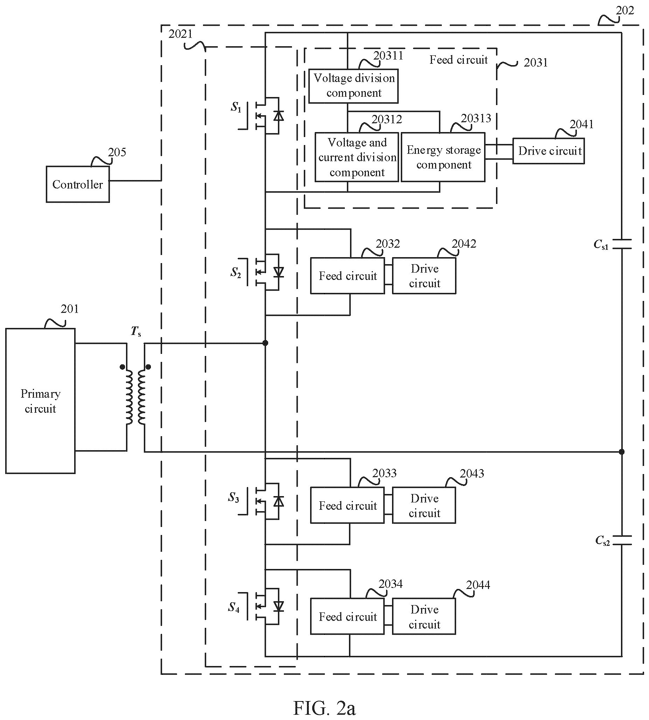

As shown in FIG. 2a, the power converter provided in this embodiment of this application includes a transformer Ts, a primary circuit 201, and a secondary circuit 202. The primary circuit 201 is connected to a primary winding of the transformer Ts, the secondary circuit 202 is connected to a secondary winding of the transformer Ts, and a voltage of the primary winding is less than a voltage of the secondary winding.

The secondary circuit 202 includes a half-bridge branch 2021, a first storage capacitor Csl, and a second storage capacitor Cs2. The first storage capacitor Cs1 and the second storage capacitor Cs2 are connected in series and then connected in parallel to the half-bridge branch 2021. The half-bridge branch 2021 includes an upper bridge arm and a lower bridge arm. The upper bridge arm or the lower bridge arm includes two switching transistors with opposite freewheeling directions (in the accompanying drawings of this application, the switching transistors of the upper bridge arm are shown as S1 and S2, and the switching transistors of the lower bridge arm are shown as S3 and S4). A connection point between the upper bridge arm and the lower bridge arm is connected to one end of the secondary winding of the transformer Ts, and a connection point between the first storage capacitor Cs1 and the second storage capacitor Cs2 is connected to the other end of the secondary winding of the transformer Ts.

It should be noted that the switching transistor in this application includes but is not limited to other power electronic devices such as a metal-oxide-semiconductor field-effect transistor (metal-oxide-semiconductor field-effect transistor, MOSFET), an insulated-gate bipolar transistor (insulated-gate bipolar transistor, IGBT), and a thyristor. In the accompanying drawings of this application, a MOSFET with a reverse-parallel diode is used as an example.

The power converter further includes at least one feed circuit (shown as feed circuits 2031 to 2034 in FIG. 2a), a drive circuit (shown as fdrive circuits 2041 to 2044 in the accompanying drawings of this application) that is correspondingly connected to the feed circuit, and a controller 205. The feed circuit and the drive circuit are separately disposed corresponding to the switching transistor.

The controller 205 is connected to a control end of each drive circuit, and an output end of each drive circuit is connected to a control end of a corresponding switching transistor (for ease of observation, a connection line between the controller 205 and the control end of each drive circuit, and a connection line between the output end of each drive circuit and the control end of the corresponding switching transistor are not shown in the accompanying drawings of this application).

It may be understood that, the feed circuit is needed to provide a stable voltage to a power supply end of the drive circuit, and further, the controller 205 is needed to output a pulse width modulation signal to the drive circuit.

A bridge drive circuit is used as an example. The drive circuit may be considered as a transformer structure, and the drive circuit includes a primary side and a secondary side. In a running process of the drive circuit, the controller 205 outputs a pulse width modulation signal to the primary side of the drive circuit to control the switching transistor in the power converter to be turned on or off, and the feed circuit supplies power to the secondary side of the drive circuit, to amplify the low-voltage pulse width modulation signal input at the primary side and provide energy for controlling the switching transistor to be turned on or off.

For example, the controller 205 outputs a pulse width modulation signal of 3.3 V to a primary side of the drive circuit 2041. When the switching transistor S1 is turned off, the feed circuit 2031 feeds power from two ends of the switching transistor S1, and outputs a voltage of 5 V to a secondary side of the drive circuit 2041. The drive circuit 2041 amplifies the pulse width modulation signal, and the amplified pulse width modulation signal controls the switching transistor S1 to be turned on or off.

Still with reference to FIG. 2a, each feed circuit includes a voltage division component 20311, a voltage and current division component 20312, and an energy storage component 20313, where the voltage division component 20311 and the voltage and current division component 20312 are connected in series and then connected in parallel to a source and a drain of a corresponding switching transistor, the voltage and current division component 20312 is connected in parallel to the energy storage component 20313, and an output end of the energy storage component 20313 is connected to a power supply end of a corresponding drive circuit.

Each voltage division component 20311 is configured to: when the corresponding switching transistor is turned off, perform voltage division on a drain-source voltage of the switching transistor, where the drain-source voltage is generated by the secondary circuit 202 by inducing a voltage of the primary circuit 201.

For example, if the primary circuit 201 shown in FIG. 2a is a full-bridge circuit, the controller 205 controls a switching transistor of the full-bridge circuit to be turned on or off, so that a variable voltage is generated on the secondary circuit 202. In this case, a voltage across two ends of the switching transistor continuously jumps. Therefore, a drain-source voltage variation dv/dt of the switching transistor is not zero.

Each voltage and current division component 20312 is configured to: when the corresponding switching transistor is turned off, perform voltage division on the drain-source voltage of the switching transistor, and perform current division on a current flowing into the voltage and current division component 20312.

It should be noted that a voltage obtained through voltage division performed by the voltage division component 20311 is greater than a voltage obtained through voltage division performed by the voltage and current division component 20312.

Each energy storage component 20313 is configured to: be charged when the corresponding switching transistor is turned off, and be discharged when the corresponding switching transistor is turned on, to supply power to the power supply end of the drive circuit.

Because the secondary circuit 202 is a high-voltage side of the transformer Ts, and a voltage difference between a drain and a source of a switching transistor of the secondary circuit 202 is relatively large, in this solution design, the voltage division component 20311 clamps voltages of the voltage and current division component 20312 and the energy storage component 20313 at a low level in a series voltage division manner, to avoid overvoltage damage of the energy storage component 20313, and reduce selection costs of the voltage and current division component 20312 and the energy storage component 20313. In addition, the voltage and current division component 20312 and the energy storage component 20313 are connected in parallel for current division, to avoid an excessively high current flowing into the energy storage component 20313, thereby avoiding overvoltage damage to the energy storage component 20313 caused by a continuous voltage rise of the energy storage component 20313 . According to the technical solution of this application, the feed circuit may feed power from two ends of the switching transistor and supply power to the power supply end of the drive circuit, no additional active circuit is required for voltage limiting, the topology is simple, and the energy storage component 20313 has no risk of overcurrent and overvoltage in charging and discharging processes, so that the stability of the feed circuit is higher.

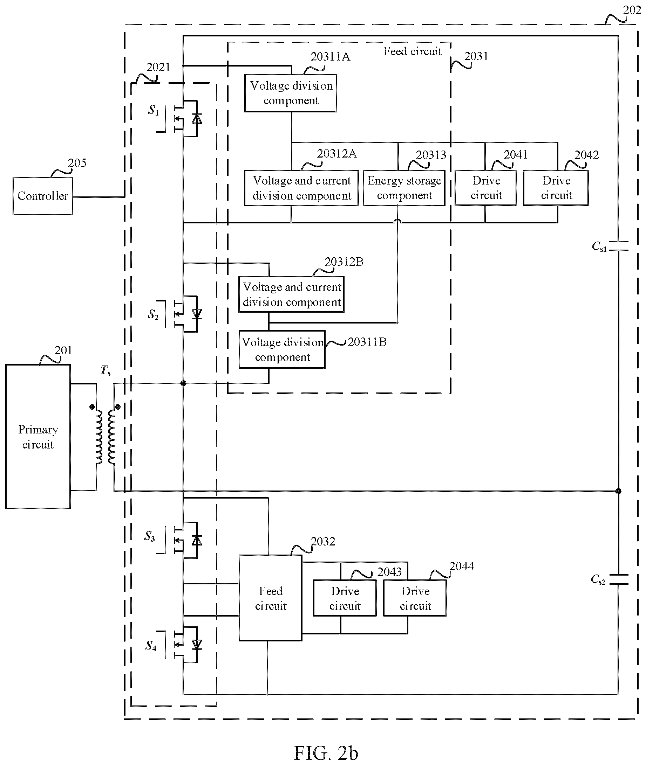

Based on a same technical concept, an embodiment of this application further provides another power converter. As shown in FIG. 2b, the power converter includes a transformer Ts, a primary circuit 201, and a secondary circuit 202. The primary circuit 201 is connected to a primary winding of the transformer Ts, the secondary circuit 202 is connected to a secondary winding of the transformer Ts, and a voltage of the primary winding is less than a voltage of the secondary winding.

The secondary circuit 202 includes a half-bridge branch 2021, a first storage capacitor Cs1, and a second storage capacitor Cs2. The first storage capacitor Cs1 and the second storage capacitor Cs2 are connected in series and then connected in parallel to the half-bridge branch 2021. The half-bridge branch 2021 includes an upper bridge arm and a lower bridge arm. The upper bridge arm or the lower bridge arm includes two switching transistors with opposite freewheeling directions. A connection point between the upper bridge arm and the lower bridge arm is connected to one end of the secondary winding of the transformer Ts, and a connection point between the first storage capacitor Cs1 and the second storage capacitor Cs2 is connected to the other end of the secondary winding of the transformer Ts.

The power converter further includes at least one feed circuit (shown as a feed circuit 2031 and a feed circuit 2032 in FIG. 2b), a drive circuit that is correspondingly connected to the feed circuit, and a controller 205. The drive circuit is disposed corresponding to the switching transistor, and the feed circuit is separately disposed corresponding to the upper bridge arm and the lower bridge arm.

Each feed circuit includes two voltage division components (shown as a voltage division component 20311A and a voltage division component 20311B in FIG. 2b), two voltage and current division components (shown as a voltage and current division component 20312A and a voltage and current division component 20312B in FIG. 2b), and an energy storage component 20313. The two voltage division components and the two voltage and current division components are separately disposed corresponding to the switching transistors. A voltage division component and a voltage and current division component that correspond to a same switching transistor are connected in series and then connected in parallel to a source and a drain of the corresponding switching transistor. The voltage and current division components are connected in parallel to the energy storage component 20313, and an output end of the energy storage component 20313 is connected to power supply ends of two corresponding drive circuits.

Each voltage division component is configured to: when the corresponding switching transistor is turned off, perform voltage division on a drain-source voltage of the switching transistor, where the drain-source voltage is generated by the secondary circuit 202 by inducing a voltage of the primary circuit 201.

Each voltage and current division component is configured to: when the corresponding switching transistor is turned off, perform voltage division on the drain-source voltage of the switching transistor, and perform current division on a current flowing into the voltage and current division component, where a voltage obtained through voltage division performed by the voltage division component is greater than a voltage obtained through voltage division performed by the voltage and current division component.

Each energy storage component is configured to: be charged when the corresponding switching transistor is turned off, and be discharged when the switching transistor is turned on, to supply power to the power supply ends of the connected drive circuits.

Based on the technical solution of this application, the voltage division component and the voltage and current division component are connected in series for voltage division, to clamp voltages of the voltage and current division component and the energy storage component at a low level, to avoid an excessively high voltage of the energy storage component. The voltage and current division component and the energy storage component are connected in parallel for current division, to avoid an excessively high current flowing into the energy storage component. Therefore, the energy storage component may feed power from two ends of the switching transistor and store the power, to supply power to the power supply ends of the drive circuits. In the technical solution of this application, no additional active circuit is required for voltage limiting, the topology is simple, and the energy storage component has no risk of overcurrent and overvoltage, so that the stability of the feed circuit is higher.

In addition, compared with the power converter in FIG. 2a that stores energy by using two energy storage components and separately supplies power to power supply ends of two drive circuits, in the technical solution in this embodiment, only one energy storage component is needed to supply power to the power supply ends of the two drive circuits, thereby reducing hardware costs.

The following describes the power converters in FIG. 2a and FIG. 2b in detail with reference to embodiments. For ease of observation, only an internal structure of the feed circuit corresponding to the switching transistor S1 is described. For a structure of a feed circuit corresponding to another switching transistor, refer to the internal structure of the feed circuit corresponding to the switching transistor S1.

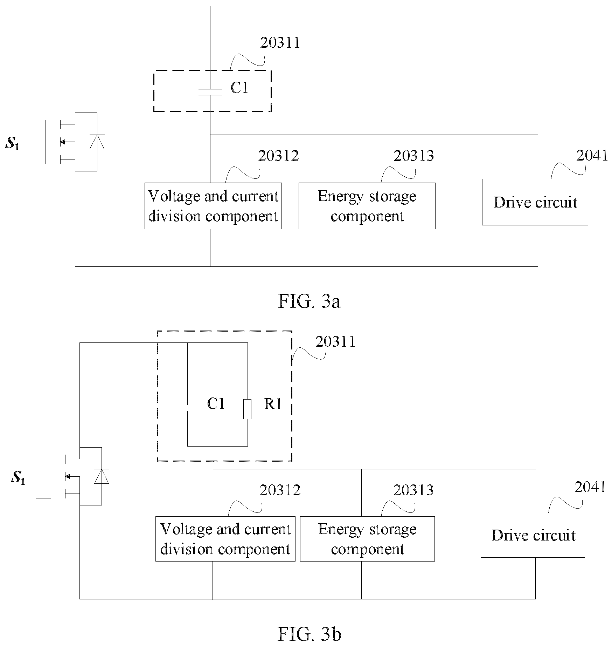

In a possible embodiment, as shown in FIG. 3a, the voltage division component 20311 includes a first capacitor C1.

The first capacitor C1 is configured to: be charged when the corresponding switching transistor is turned off, and be discharged, when the switching transistor is turned on, to zero charge through a loop including a drain-source path of the switching transistor, the first capacitor C1, and the voltage and current division component 20312.

It may be understood that, when the switching transistor is turned on, the voltage across the two ends returns to zero, and a voltage on the first capacitor C1 is unsustainable and needs to be discharged to zero potential. Otherwise, normal working of the switching transistor is affected.

Based on the technical solution in this embodiment, the first capacitor C1 is charged when the switching transistor is turned off, and is connected to the voltage and current division component 20312 in series for voltage division, to clamp voltages of the voltage and current division component 20312 and the energy storage component 20313 at a low level; and the first capacitor C1 is discharged, when the switching transistor is turned on, to zero potential through a loop including the drain-source path of the switching transistor, the first capacitor C1, and the voltage and current division component 20312.

In a possible embodiment, as shown in FIG. 3b, the voltage division component 20311 further includes a first resistor R1, where the first resistor R1 is connected in parallel to the first capacitor C1.

It may be understood that, in addition to voltage division performed by using the capacitor device shown in FIG. 3a, the voltage division component 20311 of the feed circuit in this application may further perform voltage division in a resistor-capacitor parallel connection manner shown in FIG. 3b, to further facilitate selection of the first capacitor C1. A person skilled in the art should learn that if another device may be used to implement same or similar technical effect as that of the voltage division component 20311 in this application, this application is also intended to include these modifications and variations.

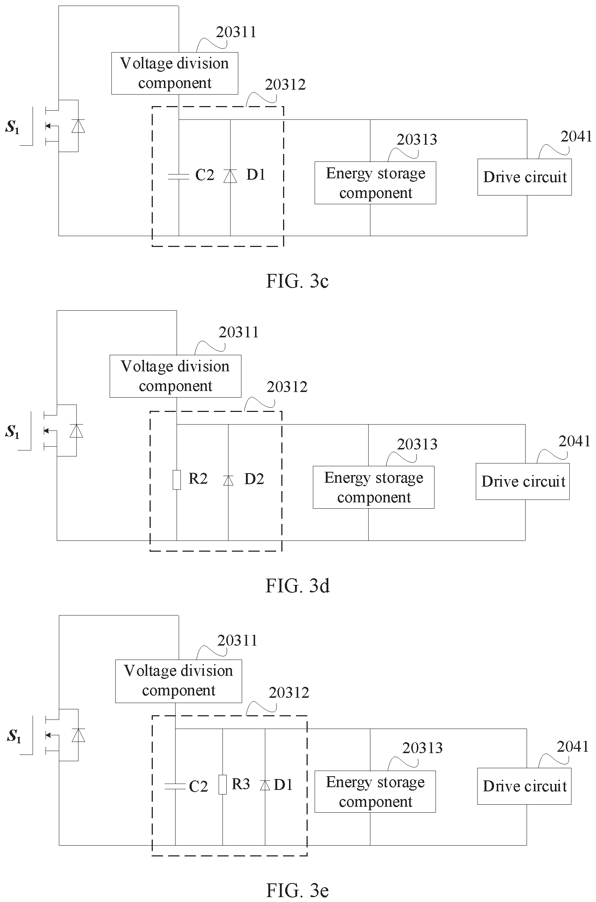

In a possible embodiment, as shown in FIG. 3c, the voltage and current division component 20312 includes a second capacitor C2 and a first diode D1, where the first diode D1 and the second capacitor C2 are connected in parallel with a same polarity.

The second capacitor C2 is configured to: be charged when the corresponding switching transistor is turned off, and be discharged, when the switching transistor is turned on, to zero charge through a loop including the drain-source path of the switching transistor, the voltage division component 20311, and the second capacitor C2.

It may be understood that, when the switching transistor is turned on, the voltage across the two ends returns to zero, and a voltage on the second capacitor C2 is unsustainable and needs to be discharged to zero potential. Otherwise, normal working of the switching transistor is affected.

Based on the technical solution in this embodiment, the second capacitor C2 performs current division when the switching transistor is turned off, to avoid an excessively high current flowing into the energy storage component 20313, and implement effect of output voltage regulation. In addition, when the switching transistor is turned on, because the first diode D1 and the second capacitor C2 are connected in parallel with a same polarity, and a voltage of the voltage division component 20311 is greater than a voltage of the voltage and current division component 20312 after charging, in a discharging process, the voltage and current division component 20312 with a relatively low voltage is generally discharged completely first, and the energy storage device in the voltage division component 20311 may continue to be discharged to zero potential by using the first diode D1.

In a possible embodiment, as shown in FIG. 3d, the voltage and current division component 20312 includes a second resistor R2 and a second diode D2, where the second diode D2 and the second resistor R2 are connected in parallel with a same polarity.

Based on the technical solution in this embodiment, when the switching transistor is turned off, the second resistor R2 may implement voltage and current division. In addition, when the switching transistor is turned on, the second diode D2 may short-circuit the second resistor R2, to accelerate a discharge speed of the first capacitor C1 in the feed circuit.

In a possible embodiment, as shown in FIG. 3e, the voltage and current division component 20312 further includes a third resistor R3, where the third resistor R3 is connected in parallel to the second capacitor C2.

It should be noted that, in this embodiment, in addition to voltage division performed by using the capacitor device, voltage division may be further performed in a resistor-capacitor parallel connection manner.

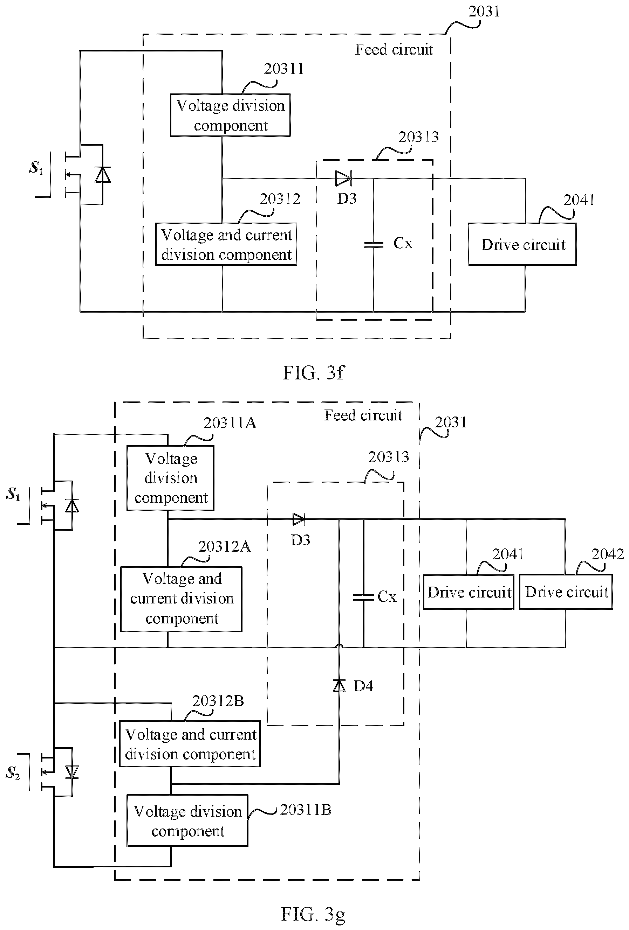

For the power converter shown in FIG. 2a, in a possible embodiment, as shown in FIG. 3f, the energy storage component 20313 includes an energy storage capacitor Cx and a third diode D3 that are connected in series, where a negative electrode of the third diode D3 is connected to a positive electrode of the energy storage capacitor Cx, and the energy storage capacitor Cx is connected in parallel to the power supply end of the drive circuit.

It should be noted that, because the energy storage capacitor Cx is mainly configured for energy storage and power supply, a capacitance value of the energy storage capacitor Cx should not be excessively small. In addition, an excessively small capacitance value of the energy storage capacitor Cx may further cause an excessively large ripple of the energy storage capacitor Cx.

For example, the voltage division component 20311 may use the picofarad-level first capacitor C1, the voltage and current division component 20312 may use the nanofarad-level second capacitor C2, and the energy storage component 20313 may use the microfarad-level energy storage capacitor Cx.

Based on the technical solution in this embodiment, in this application, the negative electrode of the third diode D3 is connected to the positive electrode of the energy storage capacitor Cx, to prevent a current from flowing back to the voltage and current division component 20312 when the energy storage capacitor Cx is discharged, resulting in no input at the power supply ends of the drive circuits.

For the power converter shown in FIG. 2b, in a possible embodiment, as shown in FIG. 3g, the energy storage component 20313 includes an energy storage capacitor Cx, a third diode D3, and a fourth diode D4, where a negative electrode of the third diode D3 and a negative electrode of the fourth diode D4 are connected to a positive electrode of the energy storage capacitor Cx, and an output end of the energy storage capacitor Cx is connected to the power supply ends of the two corresponding drive circuits.

Based on the technical solution in this embodiment, the negative electrode of the third diode D3 and the negative electrode of the fourth diode D4 are connected to the positive electrode of the energy storage capacitor Cx, to prevent a current from flowing back to the two voltage and current division components 20312 when the energy storage capacitor Cx is discharged, resulting in no input at the power supply ends of the drive circuits.

To further understand a working process of the feed circuit in this application, the following describes the working process of the feed circuit with reference to embodiments. It should be understood that for same or similar parts of embodiments of this application, refer to each other. This application is intended to cover these modifications and variations of embodiments of this application provided that they fall within the scope of the claims of this application and their equivalent technologies.

### Embodiment 1

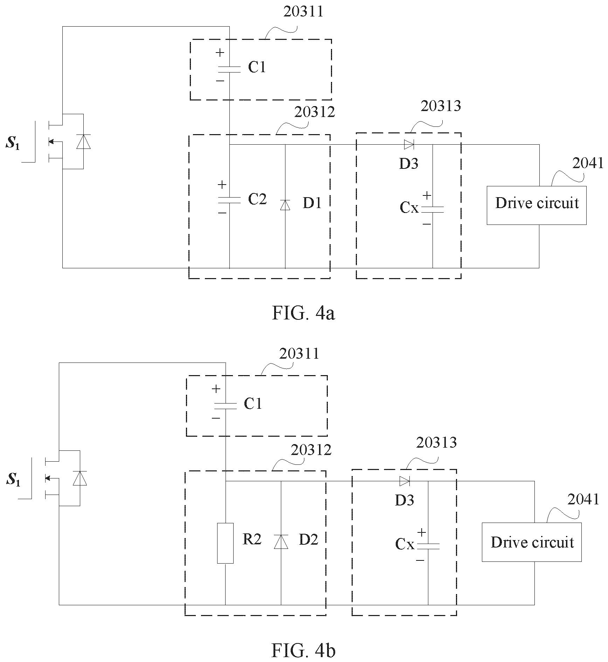

As shown in FIG. 4a, a switching transistor S1 is a MOS transistor with a reverse-parallel diode, a voltage division component 20311 includes a first capacitor C1, a voltage and current division component 20312 includes a second capacitor C2 and a first diode D1, and an energy storage component 20313 includes a third diode D3 and an energy storage capacitor Cx.

For example, when the switching transistor is turned off, there is a high voltage across two ends of the switching transistor S1, and a current flows through the first capacitor C1 and the third diode D3 to charge the energy storage capacitor Cx. The first capacitor C1 is charged and clamps a voltage of the energy storage capacitor Cx at a low level in a series voltage division manner. The second capacitor C2 is charged and avoids, in a parallel current division manner, a continuous voltage rise caused by an excessively high current of the energy storage capacitor Cx. In addition, a part of the current flows through the second capacitor C2, to implement effect of output voltage regulation.

When the switching transistor is turned on, the voltage across the two ends of the switching transistor returns to zero, and the first capacitor C1 and the second capacitor C2 are discharged to zero potential. Because a voltage of the second capacitor C2 is relatively low, charge in the second capacitor C2 is generally discharged completely first. In this case, charge in the first capacitor C1 may continue to be discharged through the first diode D1 to zero potential. The third diode D3 prevents the current from flowing back to a previous-stage component and short-circuiting a drive circuit when the energy storage capacitor Cx is discharged.

### Embodiment 2

As shown in FIG. 4b, a switching transistor S1 is a MOS transistor with a reverse-parallel diode, a voltage division component 20311 includes a first capacitor C1, a voltage and current division component 20312 includes a second resistor R2 and a second diode D2, and an energy storage component 20313 includes a third diode D3 and an energy storage capacitor Cx.

For example, when the switching transistor is turned off, there is a high voltage across two ends of the switching transistor, and a current flows through the first capacitor C1 and the third diode D3 to charge the energy storage capacitor Cx. The first capacitor C1 is charged and clamps a voltage of the energy storage capacitor Cx at a low level in a series voltage division manner. The second resistor R2 avoids, in a parallel current division manner, a continuous voltage rise caused by an excessively high current of the energy storage capacitor Cx.

When the switching transistor is turned on, the voltage across the two ends of the switching transistor returns to zero, and the first capacitor C1 is discharged to zero potential. Because the second resistor R2 is shortcircuited due to a forward path of the second diode D2, a discharge speed of the first capacitor C1 is accelerated. For example, if the second diode D2 is not disposed, and a resistance value of the second resistor R2 is excessively large, the discharge speed of the first capacitor C1 is excessively slow, thereby affecting a speed of turning on/off the switching transistor. In addition, the third diode D3 prevents the current from flowing back to a previous-stage component and short-circuiting a drive circuit when the energy storage capacitor Cx is discharged.

### Embodiment 3

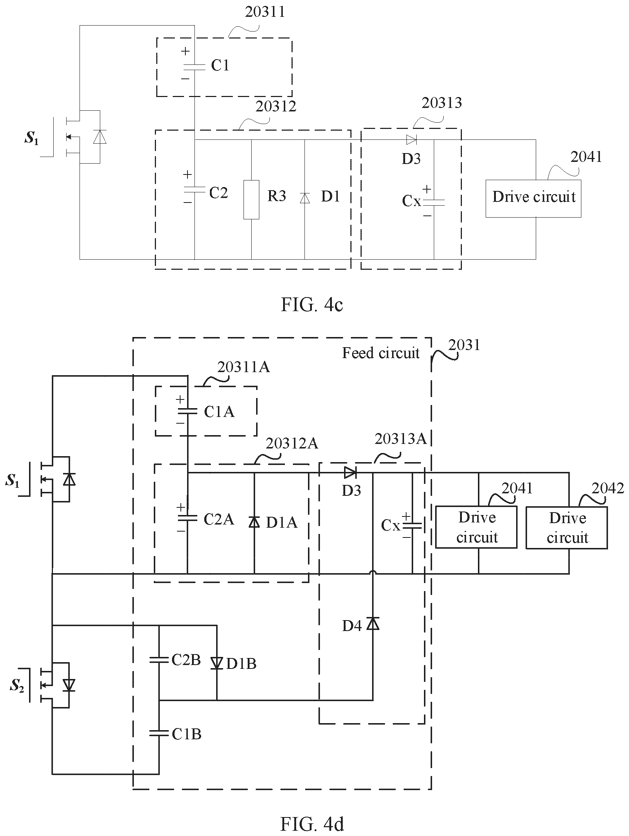

As shown in FIG. 4c, a switching transistor S1 is a MOS transistor with a reverse-parallel diode, a voltage division component 20311 includes a first capacitor C1 and a first resistor R1, a voltage and current division component 20312 includes a second capacitor C2, a second resistor R2, and a first diode D1, and an energy storage component 20313 includes a third diode D3 and an energy storage capacitor Cx.

For example, when the switching transistor is turned off, there is a high voltage across two ends of the switching transistor, and a current flows through the first capacitor C1 and the third diode D3 to charge the energy storage capacitor Cx. The first capacitor C1 is charged, and a resistor-capacitor branch including the first capacitor C1 and the first resistor R1 clamps a voltage of the energy storage capacitor Cx at a low level in a series voltage division manner. The second capacitor C2 is charged, and a resistor-capacitor branch including the second capacitor C2 and the second resistor R2 avoids, in a parallel current division manner, a continuous voltage rise caused by an excessively high current of the energy storage capacitor Cx. In addition, a part of the current flows through the second capacitor C2, to implement effect of output voltage regulation.

When the switching transistor is turned on, the voltage across the two ends of the switching transistor returns to zero, and the first capacitor C1 and the second capacitor C2 are discharged to zero potential. Because a voltage of the second capacitor C2 is relatively low, charge in the second capacitor C2 is generally discharged completely first. In this case, charge in the first capacitor C1 may continue to be discharged through the first diode D1 to zero potential. The third diode D3 prevents the current from flowing back to a previous-stage component and short-circuiting a drive circuit when the energy storage capacitor Cx is discharged.

### Embodiment 4

As shown in FIG. 4d, a switching transistor S1 is a MOS transistor with a reverse-parallel diode, a switching transistor S2 is a MOS transistor with a reverse-parallel diode, and freewheeling directions of the switching transistor S1 and the switching transistor S2 are opposite. For ease of description, it is defined that a voltage division component 20311A in FIG. 4d includes a first capacitor C1A, a voltage and current division component 20312A includes a second capacitor C2A and a first diode D1A, a voltage division component 20311B includes a first capacitor C1B, and a voltage and current division component 20312B includes a second capacitor C2B and a first diode D1B.

It may be understood that, a feed circuit 2031 may separately feed power from two ends of the turned-off switching transistors based on on/off states of the back-to-back switching transistors with the opposite freewheeling directions, and supply power to power supply ends of a next-stage drive circuit 2041 and a next-stage drive circuit 2042.

For example, when the switching transistor S1 is turned off, there is a high voltage across two ends of the switching transistor S1, and a current flows through the first capacitor C1A and the third diode D3 to charge the energy storage capacitor Cx. The first capacitor C1A is charged and clamps a voltage of the energy storage capacitor Cx at a low level in a series voltage division manner. The second capacitor C2A is charged and avoids, in a parallel current division manner, a continuous voltage rise caused by an excessively high current of the energy storage capacitor Cx. In addition, a part of the current flows through the second capacitor C2A, to implement effect of output voltage regulation.

When the switching transistor S1 is turned on, the voltage across the two ends of the switching transistor S1 returns to zero, and the first capacitor C1A and the second capacitor C2A are discharged to zero potential. Because a voltage of the second capacitor C2A is relatively low, charge in the second capacitor C2A is generally discharged completely first. In this case, charge in the first capacitor C1A may continue to be discharged through the first diode D1A to zero potential. The third diode D3 prevents the current from flowing back to a previous-stage component and short-circuiting a power supply end of a next-stage drive circuit when the energy storage capacitor Cx is discharged.

When the switching transistor S2 is turned off, there is a high voltage across two ends of the switching transistor S2, and a current flows through the first capacitor C1B and the fourth diode D4 to charge the energy storage capacitor Cx. The first capacitor C1B is charged and clamps a voltage of the energy storage capacitor Cx at a low level in a series voltage division manner. The second capacitor C2B is charged and avoids, in a parallel current division manner, a continuous voltage rise caused by an excessively high current of the energy storage capacitor Cx. In addition, a part of the current flows through the second capacitor C2B, to implement effect of output voltage regulation.

When the switching transistor S2 is turned on, the voltage across the two ends of the switching transistor S2 returns to zero, and the first capacitor C1B and the second capacitor C2B are discharged to zero potential. Because a voltage of the second capacitor C2B is relatively low, charge in the second capacitor C2B is generally discharged completely first. In this case, charge in the first capacitor C1B may continue to be discharged through the first diode D1B to zero potential. The fourth diode D4 prevents a current from flowing back to a previous-stage component and short-circuiting a power supply end of a next-stage drive circuit when the energy storage capacitor Cx is discharged.

### Embodiment 5

In some application scenarios, if an energy storage voltage of an energy storage capacitor Cx after voltage regulation of a second capacitor C2 cannot reach a standard of an input voltage of a power supply end, a voltage regulator circuit or another active voltage regulator link may be added in a feed circuit, to enable the energy storage voltage of the energy storage capacitor Cx to meet a power consumption requirement of a power supply end of a drive circuit.

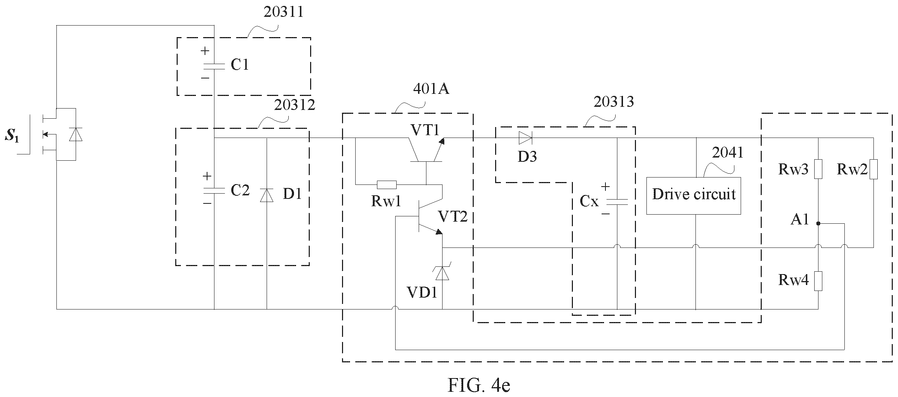

For example, on the basis of FIG. 4a, as shown in FIG. 4e, a voltage regulator circuit 401A includes a triode VT1, a triode VT2, a voltage regulator diode VD1, a resistor Rw1, a resistor Rw2, a resistor Rw3, and a resistor Rw4.

The triode VT1 is connected between the voltage and current division component 20312 and a positive electrode of the third diode D3, the resistor Rw1 is connected between an input end and a control end of the triode VT1, an input end of the triode VT2 is connected to the control end of the triode VT1, and an output end of the triode VT2 is connected to a negative electrode of the voltage regulator diode VD1. A positive electrode of the voltage regulator diode VD1 is connected to an input end of the switching transistor S1, the resistor Rw3 and the resistor Rw4 are connected in series, and a series connection node A1 is connected to a control end of the triode VT2. The resistor Rw2 is connected to a negative electrode of the third diode D3 and the output end of the triode VT2.

The voltage regulator circuit 401A is configured to regulate a voltage output by the energy storage capacitor Cx.

For example, when the energy storage voltage of the energy storage capacitor Cx does not reach a preset voltage, the triode VT1 is continuously turned on, so that the voltage across the two ends of the switching transistor continues to charge the energy storage capacitor Cx. When the energy storage voltage of the energy storage capacitor Cx reaches the preset voltage, a voltage at the control end of the triode VT2 changes, so that the triode VT2 controls the triode VT1 to be turned off, charging of the energy storage capacitor Cx is stopped, and the energy storage voltage of the energy storage capacitor Cx is regulated at the preset voltage.

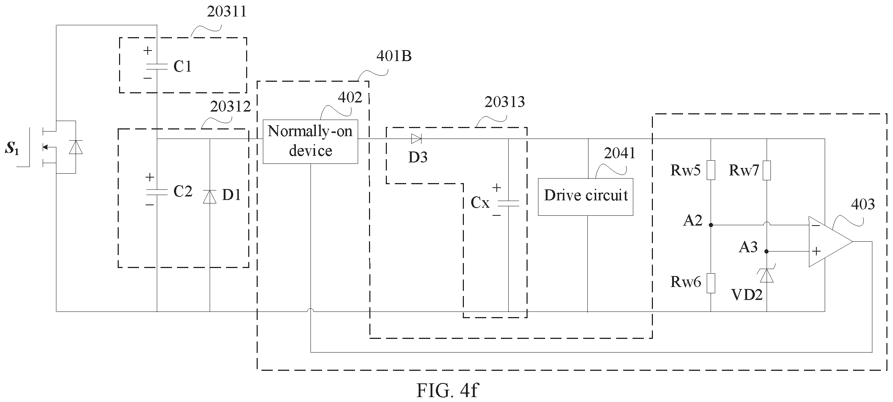

For another example, on the basis of FIG. 4a, as shown in FIG. 4f, a voltage regulator circuit 401B includes a normally-on device 402, a comparator 403, a voltage regulator diode VD2, a resistor Rw5, a resistor Rw6, and a resistor Rw7.

It should be noted that the normally-on device 402 is a device that is in an on state when a control end G3 is not driven, to enable a branch in which the device is located to be conducted. For example, the normally-on device 402 may be a DMOS transistor.

The normally-on device 402 is connected between the voltage and current division component 20312 and a positive electrode of the third diode D3, a control end of the normally-on device 402 is connected to an output end of the comparator 403, the resistor Rw5 and the resistor Rw6 are connected in series, and a series connection node A2 is connected to a negative-phase input end of the comparator 403. The resistor Rw7 is connected to a negative electrode of the voltage regulator diode VD2, and the connection node A2 is connected to a positive-phase input end of the comparator 403. A branch in which the resistor Rw5 and the resistor Rw6 are located is connected in parallel to the energy storage capacitor Cx, and a branch in which the resistor Rw7 and the voltage regulator diode VD2 are located is connected in parallel to the energy storage capacitor Cx.

The voltage regulator circuit 401B is configured to regulate a voltage output by the energy storage capacitor Cx.

For example, in a working condition in which the control end G3 is not driven by the comparator 403, the normally-on device 402 remains in the on state, so that the feed circuit 2031 feeds power from two ends of the switching transistor, and charges the energy storage capacitor Cx. When an energy storage voltage of the energy storage capacitor Cx reaches a preset voltage, the comparator 403 outputs a drive level, so that the normally-on device 402 switches to an off state, charging of the energy storage capacitor Cx is stopped, and the energy storage voltage of the energy storage capacitor Cx is regulated at the preset voltage.

In addition, a person skilled in the art should understand that, in addition to the voltage regulator circuit in this embodiment, other voltage regulator circuits may be further used to regulate the output voltage of the energy storage capacitor Cx. For example, a device like a low dropout regulator (low dropout regulator, LDO) or a voltage regulator diode and another commonly used means in this field are used to regulate the output voltage of the energy storage capacitor Cx.

Based on a same technical concept, an embodiment of this application further provides a feed circuit. For implementation of the feed circuit, refer to implementation of any feed circuit in the power converter shown in FIG. 2a. Repeated descriptions are not described again.

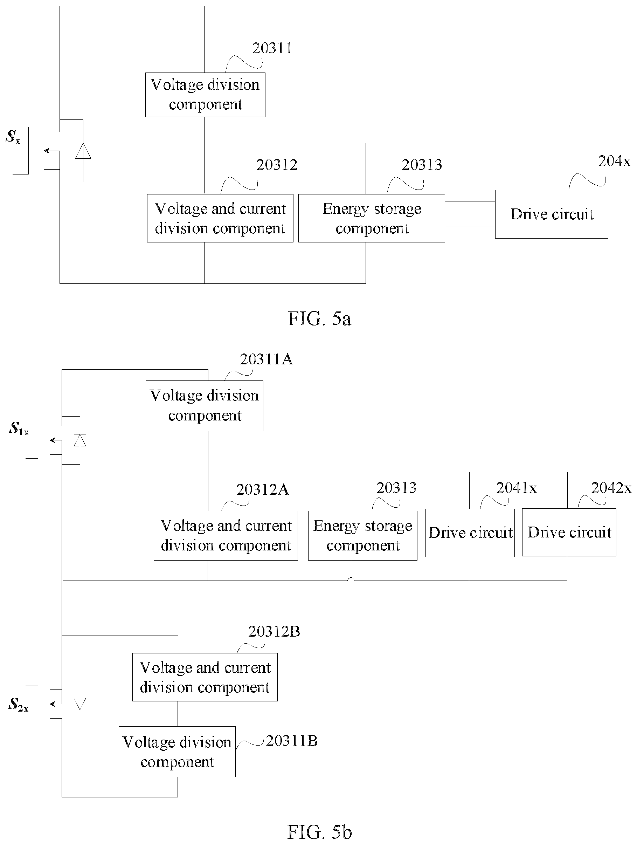

As shown in FIG. 5a, the feed circuit includes a voltage division component 20311, a voltage and current division component 20312, and an energy storage component 20313, where the voltage division component 20311 and the current division component are connected in series and then connected to a source and a drain of a switching transistor, the voltage and current division component 20312 is connected in parallel to the energy storage component 20313, an output end of the energy storage component 20313 is connected to a power supply end of a drive circuit 204x, a drive end of the drive circuit 204x is connected to a control end of a switching transistor Sx (for ease of observation, a connection line between the drive end of the drive circuit 204x and the control end of the switching transistor Sx is not shown in FIG. 5a).

It should be noted that, when the switching transistor Sx is turned off, a drain-source voltage variation of the switching transistor Sx is not zero, and a voltage of the voltage division component 20311 is greater than a voltage of the voltage and current division component 20312.

The energy storage component 20313 is configured to store electric energy when the switching transistor Sx is turned off, where the electric energy stored in the energy storage component 20313 is used to supply power to the power supply end of the drive circuit 204x.

Based on a same technical concept, an embodiment of this application further provides another feed circuit. For implementation of the feed circuit, refer to implementation of any feed circuit in the power converter shown in FIG. 2b. Repeated descriptions are not described again.

As shown in FIG. 5b, the feed circuit includes two voltage division components (shown as a voltage division component 20311A and a voltage division component 20311B in FIG. 5b), two voltage and current division components (shown as a voltage and current division component 20312A and a voltage and current division component 20312B in FIG. 5b), and an energy storage component 20313, where either of the voltage division components and either of the current division components are connected in series and then connected to a source and a drain of a switching transistor Sx1, the other voltage division component and the other current division component are connected in series and then connected to a source and a drain of another switching transistor Sx2, and the two switching transistors are connected in series and have opposite freewheeling directions. The two voltage and current division components are separately connected in parallel to the energy storage component 20313, an output end of the energy storage component 20313 is connected to power supply ends of two drive circuits (shown as a drive circuit 2041x and a drive circuit 2042x in FIG. 5b), and a drive end of each drive circuit is connected to a control end of a corresponding switching transistor.

It should be noted that, when either of the switching transistors is turned off, a drain-source voltage variation of the switching transistor is not zero, and a voltage of a voltage division component corresponding to the switching transistor is greater than a voltage of a voltage and current division component corresponding to the switching transistor.

The energy storage component 20313 is configured to store electric energy when the switching transistor is turned off, where the electric energy stored in the energy storage component 20313 is used to supply power to the power supply ends of the two drive circuits.

It is clear that a person skilled in the art can make various modifications and variations to this application without departing from the scope of this application. This application is intended to cover these modifications and variations of this application provided that they fall within the scope of the claims of this application and their equivalent technologies.

## Claims

1. A power converter, wherein the power converter comprises a transformer, a primary circuit, and a secondary circuit, the primary circuit is connected to a primary winding of the transformer, the secondary circuit is connected to a secondary winding of the transformer, and a voltage of the primary winding is less than a voltage of the secondary winding;
the secondary circuit comprises a half-bridge branch, a first storage capacitor, and a second storage capacitor, the first storage capacitor and the second storage capacitor are connected in series and then connected in parallel to the half-bridge branch, the half-bridge branch comprises an upper bridge arm and a lower bridge arm, the upper bridge arm or the lower bridge arm comprises two switching transistors with opposite freewheeling directions, a connection point between the upper bridge arm and the lower bridge arm is connected to one end of the secondary winding of the transformer, and a connection point between the first storage capacitor and the second storage capacitor is connected to the other end of the secondary winding of the transformer;
the power converter further comprises at least one feed circuit, a drive circuit that is correspondingly connected to the feed circuit, and a controller, wherein the feed circuit and the drive circuit are separately disposed corresponding to the switching transistor;
the controller is connected to a control end of each drive circuit, and an output end of each drive circuit is connected to a control end of a corresponding switching transistor;
each feed circuit comprises a voltage division component, a voltage and current division component, and an energy storage component, wherein the voltage division component and the voltage and current division component are connected in series and then connected in parallel to a source and a drain of a corresponding switching transistor, the voltage and current division component is connected in parallel to the energy storage component, and an output end of the energy storage component is connected to a power supply end of a corresponding drive circuit;
each voltage division component is configured to: when the corresponding switching transistor is turned off, perform voltage division on a drain-source voltage of the switching transistor, wherein the drain-source voltage is generated by the secondary circuit by inducing a voltage of the primary circuit;
each voltage and current division component is configured to: when the corresponding switching transistor is turned off, perform voltage division on the drain-source voltage of the switching transistor, and perform current division on a current flowing into the voltage and current division component, wherein a voltage obtained through voltage division performed by the voltage division component is greater than a voltage obtained through voltage division performed by the voltage and current division component; and
each energy storage component is configured to: be charged when the corresponding switching transistor is turned off, and be discharged when the switching transistor is turned on, to supply power to the power supply end of the drive circuit.

2. The power converter according to claim 1, wherein the voltage division component comprises a first capacitor; and
the first capacitor is configured to: be charged when the corresponding switching transistor is turned off, and be discharged, when the switching transistor is turned on, to zero charge through a loop comprising a drain-source path of the switching transistor, the first capacitor, and the voltage and current division component.

3. The power converter according to claim 2, wherein the voltage division component further comprises a first resistor, and the first resistor is connected in parallel to the first capacitor.

4. The power converter according to any one of claims 1 to 3, wherein the voltage and current division component comprises a second capacitor and a first diode, wherein the first diode and the second capacitor are connected in parallel with a same polarity; and the second capacitor is configured to: be charged when the corresponding switching transistor is turned off, and be discharged, when the switching transistor is turned on, to zero charge through a loop comprising the drain-source path of the switching transistor, the voltage division component, and the second capacitor.

5. The power converter according to any one of claims 1 to 4, wherein the voltage and current division component comprises a second resistor and a second diode, and the second diode and the second resistor are connected in parallel with a same polarity.

6. The power converter according to claim 5, wherein the voltage and current division component further comprises a third resistor, and the third resistor is connected in parallel to the second capacitor.

7. The power converter according to any one of claims 1 to 6, wherein the energy storage component comprises an energy storage capacitor and a third diode that are connected in series, wherein a negative electrode of the third diode is connected to a positive electrode of the energy storage capacitor, and the energy storage capacitor is connected in parallel to the power supply end of the drive circuit.

8. A power converter, wherein the power converter comprises a transformer, a primary circuit, and a secondary circuit, the primary circuit is connected to a primary winding of the transformer, the secondary circuit is connected to a secondary winding of the transformer, and a voltage of the primary winding is less than a voltage of the secondary winding;
the secondary circuit comprises a half-bridge branch, a first storage capacitor, and a second storage capacitor, the first storage capacitor and the second storage capacitor are connected in series and then connected in parallel to the half-bridge branch, the half-bridge branch comprises an upper bridge arm and a lower bridge arm, the upper bridge arm or the lower bridge arm comprises two switching transistors with opposite freewheeling directions, a connection point between the upper bridge arm and the lower bridge arm is connected to one end of the secondary winding of the transformer, and a connection point between the first storage capacitor and the second storage capacitor is connected to the other end of the secondary winding of the transformer;
the power converter further comprises at least one feed circuit, a drive circuit that is correspondingly connected to the feed circuit, and a controller, wherein the drive circuit is disposed corresponding to the switching transistor, and the feed circuit is separately disposed corresponding to the upper bridge arm and the lower bridge arm;
each feed circuit comprises two voltage division components, two voltage and current division components, and an energy storage component, the two voltage division components and the two voltage and current division components are separately disposed corresponding to the switching transistors, a voltage division component and a voltage and current division component that correspond to a same switching transistor are connected in series and then connected in parallel to a source and a drain of the corresponding switching transistor, the voltage and current division components are connected in parallel to the energy storage component, and an output end of the energy storage component is connected to power supply ends of two corresponding drive circuits;
each voltage division component is configured to: when the corresponding switching transistor is turned off, perform voltage division on a drain-source voltage of the switching transistor, wherein the drain-source voltage is generated by the secondary circuit by inducing a voltage of the primary circuit;
each voltage and current division component is configured to: when the corresponding switching transistor is turned off, perform voltage division on the drain-source voltage of the switching transistor, and perform current division on a current flowing into the voltage and current division component, wherein a voltage obtained through voltage division performed by the voltage division component is greater than a voltage obtained through voltage division performed by the voltage and current division component; and
each energy storage component is configured to: be charged when the corresponding switching transistor is turned off, and be discharged when the switching transistor is turned on, to supply power to the power supply ends of the connected drive circuits.

9. The power converter according to claim 8, wherein the voltage division component comprises a first capacitor; and
the first capacitor is configured to: be charged when the corresponding switching transistor is turned off, and be discharged, when the switching transistor is turned on, to zero charge through a loop comprising a drain-source path of the switching transistor, the first capacitor, and the voltage and current division component.

10. The power converter according to claim 9, wherein the voltage division component further comprises a first resistor, and the first resistor is connected in parallel to the first capacitor.

11. The power converter according to any one of claims 8 to 10, wherein the voltage and current division component comprises a second capacitor and a first diode, wherein the first diode and the second capacitor are connected in parallel with a same polarity; and the second capacitor is configured to: be charged when the corresponding switching transistor is turned off, and be discharged, when the switching transistor is turned on, to zero charge through a loop comprising the drain-source path of the switching transistor, the voltage division component, and the second capacitor.

12. The power converter according to any one of claims 8 to 10, wherein the voltage and current division component comprises a second resistor and a second diode, and the second diode and the second resistor are connected in parallel with a same polarity.

13. The power converter according to claim 11, wherein the voltage and current division component further comprises a third resistor, and the third resistor is connected in parallel to the second capacitor

14. The power converter according to any one of claims 8 to 13, wherein the energy storage component comprises an energy storage capacitor, a third diode, and a fourth diode, wherein a negative electrode of the third diode and a negative electrode of the fourth diode are connected to a positive electrode of the energy storage capacitor, and an output end of the energy storage capacitor is connected to the power supply ends of the two corresponding drive circuits.

15. A feed circuit, wherein the feed circuit comprises a voltage division component, a voltage and current division component, and an energy storage component, wherein the voltage division component and the voltage and current division component are connected in series and then connected to a source and a drain of a switching transistor, the voltage and current division component is connected in parallel to the energy storage component, an output end of the energy storage component is connected to a power supply end of a drive circuit, and a drive end of the drive circuit is connected to a control end of the switching transistor, wherein
when the switching transistor is turned off, a drain-source voltage variation of the switching transistor is not zero, and a voltage of the voltage division component is greater than a voltage of the voltage and current division component; and
the energy storage component is configured to store electric energy when the switching transistor is turned off, wherein the electric energy stored in the energy storage component is used to supply power to the power supply end of the drive circuit.
